# EUROPÄISCHE PATENTANMELDUNG

(11) **EP 0 987 753 A2**
(43) Veröffentlichungstag der Anmeldung: **22.03.2000**
(21) Anmeldenummer: 99117556.3
(22) Anmeldetag: 06.09.1999
(51) Int. Cl.: H01L 21/8242

(54) **Gestapelter DRAM-Flossenkondensator und Verfahren zur Herstellung desselben**

(30) Priorität: 17.09.1998 DE 19842704
(71) Anmelder: SIEMENS AKTIENGESELLSCHAFT, 80333 München (DE)
(72) Erfinder: Lange, Gerrit, Dr., 81373 München (DE); Schlösser, Till, Dr., 81825 München (DE)

(57) **Zusammenfassung**

Kondensator mit einem hoch-ε-dielektrischen oder ferroelektrischen Kondensatordielektrikum (9), dessen edelmetallhaltige Speicherelektrode mehrere horizontale Lamellen (9_{L}) aufweist, die über eine Stützstruktur (9_{S}) miteinander verbunden sind. Die Stützstruktur kann an einer oder vorzugsweise zwei gegenüberliegenden Außenflanken der Lamellen angeordnet sein. Bei der Herstellung wird zunächst (u.a. durch Abscheiden einer Schichtenfolge mit alternierend niedriger und hoher Ätzrate) eine fin-stack-Negativform, insbesondere aus p⁺-Polysilizium, gebildet, die dann konform mit dem Elektrodennmaterial aufgefüllt wird.

## Beschreibung

Die Erfindung betrifft einen Kondensator in einer integrierten Schaltung mit einer edelmetallhaltigen ersten Elektrode, bei dem als Kondensatordielektrikum ein hoch-ε-Dielektrikum oder ein Ferroelektrikum eingesetzt wird, sowie ein Herstellverfahren für einen solchen Kondensator.

In einer großen Anzahl von integrierten Halbleiterschaltungen werden Kondensatoren benötigt, beispielsweise in DRAM-Schaltungen oder A/D-Wandlern. Dabei ist die Erhöhung der Integrationsdichte ein vorrangiges Ziel, d.h. es muß eine möglichst hohe oder für die Anforderungen ausreichende Kapazität mit minimalem Platzbedarf realisiert werden. Dieses Problem stellt sich insbesondere bei DRAM-Schaltungen, bei denen jede Speicherzelle einen Speicherkondensator und einen Auswahltransistor aufweist, wobei die für eine Speicherzelle zur Verfügung stehende Fläche fortlaufend reduziert wird. Gleichzeitig muß zur sicheren Speicherung der Ladung und Unterscheidbarkeit der auszulesenden Information eine gewisse Mindestkapazität des Speicherkondensators erhalten bleiben. Diese Mindestkapazität wird derzeit bei etwa 25 fF gesehen.

Zur Verringerung des Platzbedarfe eines Kondensators kann als Kondensatordielektrikum ein Paraelektrikum mit hoher Permittivität (hoch-ε-Dielektrikum) verwendet werden. In Speicheranordnungen werden solche Kondensatoren vorzugsweise als sogenannte 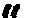 Stacked 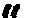 -Kondensatoren (der Kondensator der Zelle ist oberhalb des zugehörigen Auswahltransistors angeordnet) eingesetzt. Speicherzellen, die als Kondensatordielektrikum paraelektrische Materialien benutzen, verlieren bei Auswahl der Versorgungsspannung ihre Ladung und somit ihre gespeicherte Information. Ferner müssen diese Zellen wegen des Rest-Leckstroms ständig neu beschrieben werden (Refresh-Time). Der Einsatz eines ferroelektrischen Materials als Kondensatordielektrikum ermöglicht dagegen aufgrund der unterschiedlichen Polarisationsrichtungen des Ferroelektrikums den Bau eines nicht-flüchtigen Speichers (FRAM), der seine Information bei Auswahl der Versorgungsspannung nicht verliert und auch nicht ständig neu beschrieben werden muß. Der Rest-Leckstrom der Zelle beeinflußt nicht das gespeicherte Signal.

Verschiedene hoch-ε-Dielektrika und Ferroelektrika sind aus der Literatur bekannt, beispielsweise Barium-Strontium-Titanat (BST), Strontium-Titanat (ST) oder Blei-Zirconium-Titanat (BZT), ferner ferro- und paraelektrische Polymere und anderes.

Obwohl diese Materialien die gewünschten elektrischen Eigenschaften aufweisen, ist ihre Bedeutung in der Praxis noch begrenzt. Eine wesentliche Ursache dafür ist, daß die genannten Materialien nicht ohne weiteres in Halbleiteranordnungen eingesetzt werden können. Die Herstellung der Materialien erfolgt durch einen Sputter-on- oder Abscheideprozess, der hohe Temperaturen in einer sauerstoffhaltigen Atmosphäre benötigt. Dies hat zur Folge, daß die in der Halbleitertechnologie als Elektrodenmaterial verwendeten leitfähigen Materialien (z.B. Polysilizium, Aluminium oder Wolfram) ungeeignet sind, da sie unter diesen Bedingungen oxidieren. Daher wird zumindest die erste Elektrode üblicherweise aus einem edelmetallhaltigen Material wie Platin oder Ruthenium hergestellt. Diese neuen Elektrodenmaterialen sind jedoch für die Halbleitertechnologie relativ unbekannte Substanzen, die relativ schwierig aufzubringen sind. Ein besonders gravierendes Problem ist, daß sie nur bei geringer Schichtdicke befriedigend strukturierbar sind. Ferner sind sie sauerstoffdurchlässig, was zur Folge hat, daß während der Herstellung des Kondensatordielektrikums tieferliegende Strukturen oxidiert werden und ein ausreichender Kontakt zwischen erster Elektrode und dem Auswahltransistor nicht gewährleistet ist. Daher ist eine Barriere unterhalb des Kondensatordielektrikums notwendig, die eine Sauerstoffdiffusion unterdrückt.

In der DE 196 40 448 und WO 98/14992 ist eine derartige Speicherzelle beschrieben, bei der die Barriere zwischen der ersten Elektrode und der Anschlußstruktur zum Auswahltransistor ganzflächig durch eine Nitridation erzeugt wird. In der DE-OS 196 40 244 ist ein Kondensator mit einem hoch-ε-dielektrischen oder ferroelektrischen Kondensatordielektrikum beschrieben, bei dem die erste Elektrode aus einem Elektrodenkern und einer demgegenüber dünnen edelmetallhaltigen Schicht besteht, und bei dem der Elektrodenkern aus dem Material der Anschlußstruktur oder der Oxidationsbarriere besteht. Dies hat den Vorteil, daß lediglich eine dünne edelmetallhaltige Schicht strukturiert werden muß. Allen diesen Kondensatoren mit einem hoch-ε-dielektrischen oder ferroelektrischen Kondensatordielektrikum ist gemeinsam, daß eine im Prinzip planare Anordnung der ersten Elektrode vorgesehen ist.

In US 5 581 436 ist als erste Elektrode eines Kondensators der in Rede stehenden Art eine dünne Platinschicht auf der Oberfläche eines Elektrodenkerns aufgebracht. Ggf. kann das Hoch-ε-Dielektrikum als frei stehende Struktur vor der Bildung der ersten und zweiten Elektrode hergestellt werden, d.h. die Elektroden werden dann an den Seitenwänden des Dielektrikums gebildet.

Aufgabe der vorliegenden Erfindung ist es, bei einem Kondensator mit einem hoch-ε-dielektrischen oder ferroelektrischen Kondensatordielektrikum den Platzbedarf weiter zu verringern, sowie ein mit den üblichen Herstellprozessen verträgliches Herstellverfahren für einen solchen Kondensator anzugeben.

Diese Aufgabe wird durch ein Herstellverfahren mit den Merkmalen des Anspruchs 1 bzw. durch einen Kondensator mit den Merkmalen des Anspruchs 11 gelöst.

Bei der Erfindung umfaßt die erste Elektrode mindestens zwei voneinander beabstandete Lamellen, die im wesentlichen parallel zur Trägeroberfläche liegen und über eine Stützstruktur miteinander verbunden sind. Die kapazitätawirksame Oberfläche ist dadurch gegenüber der beanspruchten Trägeroberfläche wesentlich vergrößert. Die Stützstruktur kann insbesondere an einer Außenflanke der Lamellen oder an zwei gegenüberliegenden Außenflanken angeordnet sein.

Die geometrische Struktur der ersten Elektrode entspricht der Form von sogenannten 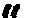 Fin-Stack-Kondensatoren", die aus dotiertem Polysilizium bestehen. Bei der Herstellung dieser bekannten Kondensatoren muß Polysilizium von hoher Schichtdicke (zusammengesetzt aus mehreren Einzelschichten) anisotrop geätzt werden, wie beispielsweise in EP 756 326 A1 oder EP 779 656 A2 beschrieben. Diese geometrische Struktur scheint für edelmetallhaltige Elektrode aufgrund ihrer schlechten Ätzbarkeit nicht zugänglich zu sein.

Das erfindungsgemäße Herstellverfahren ermöglicht die Herstellung eines Kondensators mit einer edelmetallhaltigen ersten Elektrode nach dem Fin-Stack-Prinzip, ohne daß eine anisotrope Ätzung des Elektrodenmaterials erforderlich ist. Es beruht darauf, einen vorzugsweise aus P⁺-Polysilizium bestehenden Korpus ähnlich dem das Fin-Stack-Kondensators als Negativform für einen Metallkorpus, der die speziellen Anforderungen an Elektroden bei der Verwendung von Hoch-ε-Dielektrika und Ferroelektrika erfüllt, zu benutzen.

Zur Herstellung der ersten Elektrode wird auf einem Träger, der ein Isolationsschicht mit einem darin eingebetteten Anschluß enthalten kann, eine Schichtenfolge erzeugt, die jeweils alternierend eine Schicht aus einem ersten Material und eine Schicht aus einem zweiten Material aufweist, wobei das erste Material zum zweiten selektiv ätzbar ist. Die Schichtenfolge wird dann zu einer Schichtstruktur mit Flanken geätzt. Es wird eine erste Hilfsstruktur an mindestens einer Flanke erzeugt, die aus einem ersten Hilfsmaterial besteht, daß wie das erste Material selektiv ätzbar zum zweiten Material ist. Dabei wird mindestens eine Flanke nicht von der ersten Hilfsstruktur bedeckt. Es wird eine zweite Hilfsstruktur gebildet, die mindestens eine, vorzugsweise alle verbleibenden Außenflanken der Schichtenfolge bedeckt und die Schichten aus dem zweiten Material mechanisch verbindet. Die diese Anordnung umgebende Trägeroberfläche wird bis zur Oberkannte der Schichtstruktur mit einer Füllschicht bedeckt. Dann werden die Schichten aus dem ersten Material und die erste Hilfsstruktur selektiv zu den Schichten aus dem zweiten Material und zur zweiten Hilfsstruktur entfernt. Auf dem Träger verbleiben also die Füllschicht und die mit der zweiten Hilfsstruktur untereinander verbundenen Schichten aus dem zweiten Material. Diese Struktur bildet eine Negativform mit einem Hohlraum, der durch die Entfernung der Schichten aus dem ersten Material und der ersten Hilfsstruktur entstanden ist. Der Hohlraum wird bis zur Oberkante des Füllschicht mit einem edelmetallhaltigen Elektrodenmaterial zur Bildung einer ersten Elektrode aufgefüllt. Dann werden die Schichten aus dem zweiten Material und die zweite Hilfsstruktur selektiv zum Elektrodenmaterial entfernt, vorzugsweise wird auch die Füllschicht insbesondere selektiv zur Trägeroberfläche entfernt. Damit liegt eine erste Elektrode mit freiliegender Oberfläche vor, auf der nun ein Kondensatordielektrikum aus einem hoch-ε-dielektrischen oder ferroelektrischen Material konform aufgebracht wird. Schließlich wird die zweite Elektrode auf dem Kondensatordielektrikum erzeugt.

Für das erste und das zweite Material und für die Anordnung und die Bildung der ersten und zweiten Hilfsstruktur gibt es eine Vielzahl von Möglichkeiten. Weder die Schichten aus dem ersten oder zweiten Material noch die Hilfsstrukturen verbleiben in der fertigen Halbleiteranordnung. Ihre Auswahl kann daher nach prozeßtechnischen Gesichtspunkten erfolgen, die elektrischen Eigenschaften sind unbedeutend. Die erste Hilfsetruktur besteht vorzugsweise aus dem ersten Material, die zweite Hilfsstruktur besteht vorzugsweise aus dem zweiten Material.

Als Material für die erste Elektrode ist insbesondere Platin, aber auch Rutheniumoxid und andere edelmetallhaltige Materialien geeignet, die für den Einsatz in einem hoch-ε- oder ferroelektrischen Kondensator bekannt sind und die - beispielsweise mittels MOCVD - konform in einem Hohlraum aufgebracht werden können. Die zweite Elektrode besteht vorzugsweise aus demselben Material wie die erste, kann aber auch aus einem anderen geeigneten Material, beispielsweise W oder TiN, einem anderen Metall oder dotiertem Polysilizium, gebildet werden. Die zweite Elektrode des Kondensators ist von der ersten Elektrode durch ein hoch-ε-Dielektrikum oder Ferroelektrikum getrennt.

Der Träger kann einen Anschluß für die erste Elektrode enthalten, wobei die übrige Trägeroberfläche mit einer Isolierschicht bedeckt ist. Dann bedeckt die edelmetallhaltige erste Elektrode einen Teil der Trägeroberfläche und überdeckt diesen Anschluß, so daß ein elektrischer Kontakt gewährleistet ist.

Vorzugsweise wird der Kondensator in einer DRAM-Zelle eingesetzt. Dann enthält der Träger den zugehörigen MOS-Auswahltransistor. Ein S/D-Gebiet des Transistors wird über den erläuterten Anschluß mit der ersten Elektrode verbunden. Der Anschluß weist vorzugsweise in seinem oberen Bereich eine leitende Sauerstoffbarriere auf (beispielsweise Titannitrid) und besteht im übrigen aus beispielsweise Titan, Polysilizium, Wolfram oder ähnlichem.

Bei einer bevorzugten Ausführungsform des Herstellverfahrens bestehen die Schichten aus dem ersten Material aus p⁻-dotiertem Polysilizium oder undotiertem Polysilizium und die Schichten aus dem zweiten Material aus p⁺ dotiertem Polysilizium. Die erste Hilfstruktur kann dann durch selektive Silizium-Abscheidung von undotiertem oder auch n- oder p⁻ dotiertem Polysilizium erzeugt werden. An vorzugsweise zwei sich gegenüber liegenden Außenflanken der Schichtstruktur wird die epitaktische bzw. selektiv abgeschiedene Schicht dann wieder entfernt. Alternativ, insbesondere bei anderer Wahl des ersten und zweiten Materials, kann die erste Hilfsstruktur auch als Spacer oder durch eine Seitenwand-Implantation in eine oder zwei der Schichtstruktur erzeugt werden. Die zweite Hilfsstruktur wird bei dem genannten Schichtsystem vorzugsweise durch seitliche mit Bor-Ionen erzeugt. Alternativ kann statt einer seitlichen Bor-Implantation eine selektive Si-Abscheidung von p⁺-dotiertem Polysilizium durchgeführt werden. Wenn beide Hilfsstrukturen mit Hilfe von Epitaxie erzeugt werden, kann die Reihenfolge der selektiven p⁺ bzw. p⁻-Abscheidung auch vertauscht werden, d.h. die zweite Hilfsstruktur wird vor der ersten Hilfsstruktur hergestellt.

Die Füllschicht wird vorzugsweise durch Abscheidung einer dicken Siliziumoxidschicht mit anschließendem Rückschleifen (CMP) bis auf die Höhe der Schichtstruktur erzeugt, d.h. bis die erste Hilfsstruktur oder die oberste Schicht aus dem ersten Material mindestens teilweise freiliegt.

Obwohl allgemein anwendbar, werden in folgenden der Kondensator und das Herstellverfahren an Beispiel einer DRAM-Zellenanordnung beschrieben.

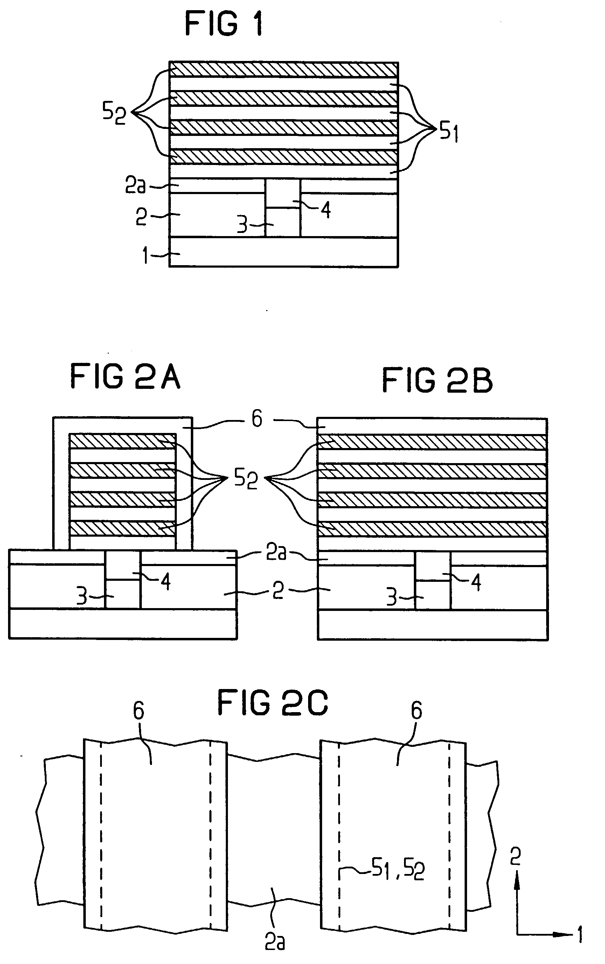

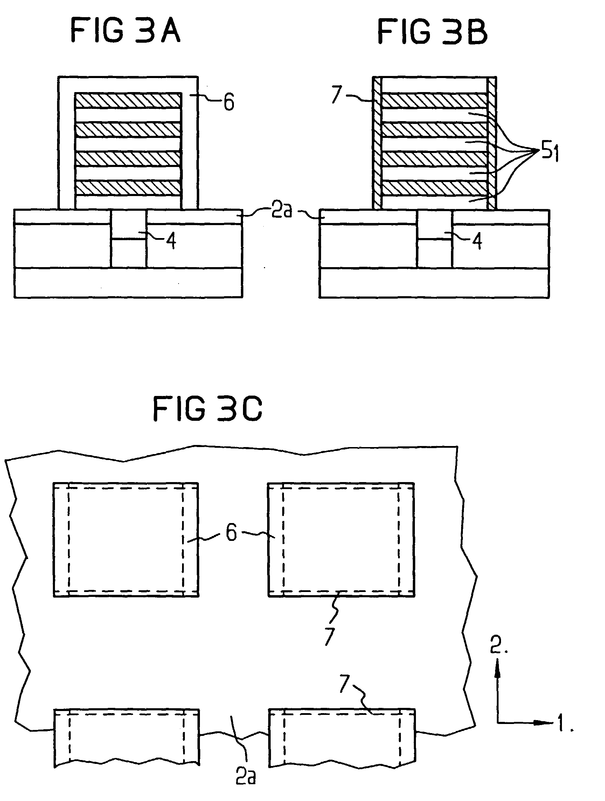

Die Figuren 1 bis 10, (jeweils a, b) zeigen ein Halbleitersubstrat in Querschnitt zu Erläuterung der Verfahrungsschritte, wobei die Schnittebenen der Figurenteile a und b jeweils senkrecht zu einander sind. Die Figuren 2c und 3c zeigen eine Aufsicht auf das Substrat beim jeweiligen Verfahrensschritt.
FIG 1: Auf ein Substrat 1 wird eine isolierende Schicht 2 aufgebracht, die vorzugsweise eine Ätzstopschicht 2a an ihrer oberen Oberfläche umfaßt. Das Substrat 1 ist beispielsweise ein Siliziumsubstrat, das Auswahltransistoren mit Wortleitungen und Bitleitungen umfaßt (s. Fig.9). Die isolierende Schicht wird beispielsweise aus Siliziumoxid gebildet und planarisiert, die Ätzstopschicht 2a besteht vorzugsweise aus Siliziumnitrid. In der isolierenden Schicht 2, 2a werden Kontaktlöcher 3 geöffnet und mit elektrisch leitfähigem Material, beispielsweise mit dotiertem Polysilizium, Wolfram, Tantal, Titan, Titannitrid oder Wolframsilizid aufgefüllt. Die Kontaktlöcher 3 werden so angeordnet, daß sie jeweils auf ein Source-/Draingebiet eines Auswahltransistors im Substrat 1 reichen. Vorzugsweise im oberen Teil des Kontaktlochs 3 ist eine Barriere 4 angeordnet, die eine Sauerstoffdiffusion unterdrückt. Verfahren zur Herstellung einer solchen Barriere sind beispielsweise aus DE-OS 196 40 246 und DE-OS 196 40 448 bekannt. Auf der Oberfläche dieses Trägers wird nun eine Schichtenfolge aufgebracht wird, die alternierend eine Schicht 5₁ aus einem ersten Material und eine Schicht 5₂ aus einem zweiten Material umfaßt. Vorzugsweise besteht das erste Material aus p⁻-dotiertem oder undotiertem Polysilizium und das zweite Material aus p⁺-dotiertem Polysilizium. Das erste Material muß selektiv zum zweiten Material, zur Trägeroberfläche 2a und zum Barrierenmaterial 4 ätzbar sein. Die Schichtdicken liegen vorzugsweise im Bereich 20 - 100nm. In diesem Ausführungsbeispiel besteht die oberste Schicht der Schichtenfolge aus dem zweiten Material.
FIG 2: Anschließend werden aus der Schichtenfolge durch anisotropes Ätzen unter Verwendung einer Maske streifenförmige Schichtstrukturen 5 gebildet, die Streiten verlaufen entlang einer 2. Richtung (in Fig. 2c gestrichelt dargestellt). Im Figurenteil a ist das Substrat entlang einer ersten Richtung im Schnitt dargestellt, im Figurenteil b in der dazu senkrechten 2. Richtung. In der 1. Richtung entspricht die Breite eines Streifens den herzustellenden Kondensatorlamellen. Neben der Schichtstruktur 5₁, 5₂ liegt die Oberfläche der isolierenden Schicht, hier also der Ätzstopschicht 2a, frei. Dann wird mittels selektiver Abscheidung eine Schicht 6 vorzugsweise aus undotiertem Silizium oder aus p⁻-dotiertem Silizium aufgebracht, d.h. die streifenförmigen Schichtstrukturen werden überwachsen.
Figur 3: Es wird eine Photolack- oder Hartmaske aufgebracht, die in der ersten Richtung verlaufende Streifen aufweist. Mit dieser Ätzmaske wird eine anisotrope Ätzung der Polysiliziumschichten 5₁, 5₂, 6 vorgenommen, so daß die in der zweiten Richtung verlaufenden Siliziumstreifen in einzelne Inseln getrennt werden. Diese Inseln, die aus den Schichten aus dem ersten Material 5₁, den Schichten aus den zweiten Material 5₂ und der Siliziumschicht 6 bestehen, definieren jeweils Ort und Größe einer einzelnen Kondensatorelektrode. Die selektive Siliziumschicht 6 bedeckt dabei jeweils zwei in der ersten Richtung gegenüberliegende Außenflanken einer inselförmigen Schichtstruktur und stellt die erste Hilfsstruktur dar. Die in der zweiten Richtung gegenüberliegenden Außenflanken der Insel werden nicht von der ersten Hilfsstruktur bedeckt, hier liegt die Schichtenfolge 5₁, 5₂ frei. Diese Außenflanken 5₁, 5₂, 6 werden nun seitlich mit Bor implantiert, so daß an ihnen eine zweite Hilfsstruktur 7 bestehend aus p⁺-dotiertem Siliziurn gebildet wird. Danach wird die Maske entfernt. Alternativ kann anstelle der Implantation auch eine p⁺-Siliziumschicht an den in der zweiten Richtung gegenüberliegenden Außenflanken selektiv abgeschieden werden, und zwar ebenfalls vor Entfernung der Maske. Diese p⁺-Siliziumschicht stellt dann die zweite Hilfsstruktur 7 dar.

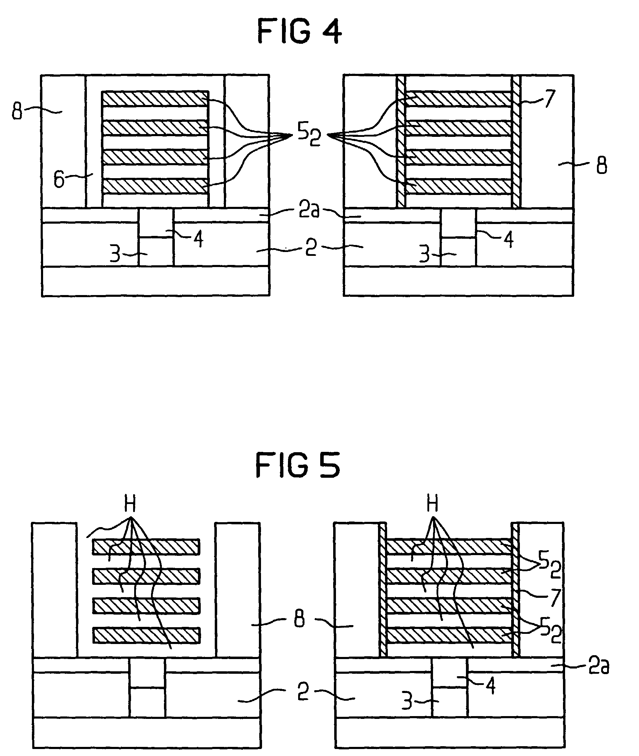

Figur 4: Die Zwischenräume zwischen den inselförmigen Strukturen werden mit einer Füllschicht 8 aufgefüllt. Dazu wird vorzugsweise eine Siliziumoxidschicht von ausreichender Dicke aufgebracht und bis auf die Höhe der aberkannte der inselförmigen Strukturen, hier also der Siliziumschicht 6, mittels CMP (Chemical Mechanical Polishing) zurückgeschliffen. Die Füllschicht besteht vorzugsweise aus einem Material, das selektiv zur Trägeroberfläche, hier also zur Nitrid-Ätzstopschicht 2a, ätzbar ist.

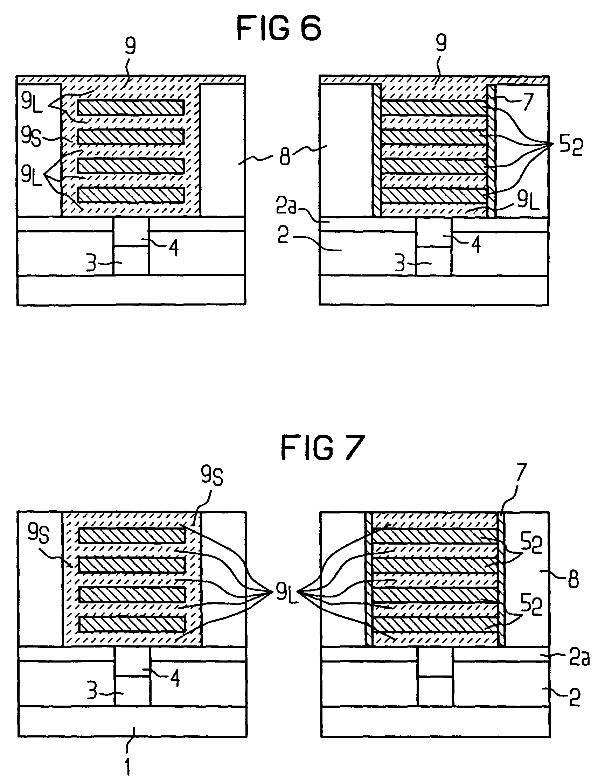

Figur 5: Die Schichten aus dem ersten Material 5₁ und die erste Hilfsstruktur 6, die hier aus p⁻-dotiertem Silizium bestehen, werden selektiv zu den Schichten aus dem zweiten Material und der zweiten Hilfsstruktur 7 (p⁺-Silizium) und zur Füllschicht 8 entfernt. Geeignete Ätzverfahren mit isotroper Komponente sind dem Fachmann bekannt. Die p⁺-dotierten Siliziumschichten 5₂ und die p⁺-dotierten Seitenwände 7 bleiben stehen und bilden ein leiterförmiges Gerüst, das zusammen mit der Füllschicht eine Negativform mit Hohlräumen H an den Orten der p⁻-dotierten Siliziumschichten und der ersten Hilfestruktur darstellt.
Figur 6: Der Hohlraum H wird mit einem für hoch-ε-Dielektrika oder Ferroelektrika geeigneten Elektrodenmaterial 9, also insbesondere Platin, Iridium, Rutheniumoxid oder einem anderen edelmetallhaltigen Material, konform aufgefüllt. Platin kann beispielsweise mittels MOCVD konform aufgebracht werden. Dabei wird auch auf der Füllschicht 8 Platin abgeschieden.
Figur 7: Das auf der Füllschicht 8 befindliche Elektrodenmaterial wird mittels CMP oder Rückätzen entfernt. Dadurch wird die erste Elektrode des Kondensators, die aus voneinander beanstandeten Lamellen 9_{L} und seitlichen Stützstrukturen 9_{S} besteht, fertiggestellt. Gleichzeitig werden die Elektroden benachbarter Kondensatoren voneinander getrennt.

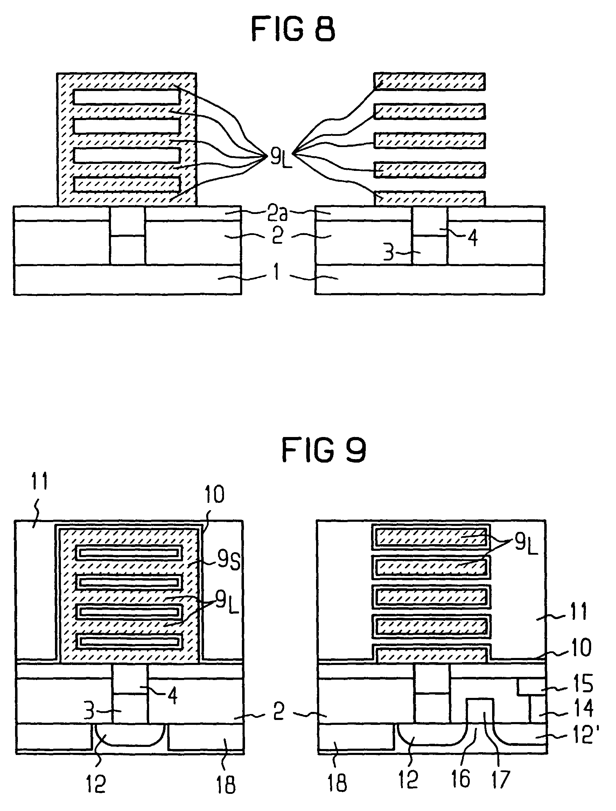

Figur 8: Die Füllschicht 8 wird bis zur unterliegenden Ätzstopschicht 2a entfernt. Vorzugsweise danach wird das p⁺-Silizium, das nur als Negativform für die erste Elektrode diente, selektiv zum Elektrodenmaterial entfernt.
Figur 9: Auf der so erhaltenen freiliegenden Oberfläche der ersten Elektrode 9 wird als Kondensatordielektrikum 10 ein hoch-ε-Dielektrikum oder Ferroelektrikum konform abgeschieden. Anschließend wird die Gegenelektrode 11 aus einem geeigneten leitfähigen Material (z.B. Platin, Wolfram, Titan-Nitrid) aufgebracht.

In dieser Figur 9 sind auch weitere im Träger realisierte Strukturen dargestellt, die bei Einsatz des Kondensators in einer DRAM-Schaltung vorhanden sind. Die erste Elektrode 9_{L}, 9_{S} bildet den sogenannten Speicherknoten für einen Speicherkondensator. Diese erste Elektrode ist über den darunter angeordneten und mit der Diffusionsbarriere 4 versehenen Kontakt 3 mit einem Source-/Drain-Gebiet 12 eines Auswahltansistors verbunden. Das andere Source-/Drain-Gebiet 12' des Auswahltransistors ist über einen Bitleitungskontakt 14 mit einer vergrabenen Bitleitung 15 verbunden. Vorzugsweise besitzen zwei benachbarte Speicherzellen einen gemeinsamen Bitleitungskontakt. Die vergrabene Bitleitung 15 und der Bitleitungskontakt 14 sind von der isolierenden Schicht 2 umgeben. Zwischen den Source-/Drain-Gebieten 12 und 12' eines Auswahltransistors sind das Kanalgebiet 16, ein Gatedielektrikum (nicht dargestellt) und eine als Wortleitung 17 wirkende Gateelektrode angeordnet. Die Wortleitung 17 und der Bitleitungskontakt 14 sind jeweils aus dotiertem Polysilizium gebildet. Die Bitleitung 15 wird aus dotiertem Polyslilizium, Wolframsilizid oder Wolfram gebildet. Auf der der Bitleitung 15 abgewandten Seite des S-/D-Gebietes 12 ist jeweils eine Isolationsetruktur, beispielsweise ein flacher mit isolierendem Material gefüllter Graben 18 zur Isolation zwischen benachbarten Auswahltransistorpaaren vorgesehen.

## Patentansprüche

1. Herstellverfahren für einen Kondensator in einer Halbleiteranordnung auf einem Träger,
- bei dem auf der Oberfläche des Trägers (2a) eine Schichtenfolge erzeugt wird, die jeweils alternierend eine Schicht aus einem ersten Material (5₁) und eine Schicht aus einem zweiten Material (5₂) umfaßt, wobei das erste Material selektiv zum zweiten Material ätzbar ist,
- bei dem die Schichtenfolge zu einer Schichtstruktur (5) mit Flanken geätzt wird,
- bei dem eine erste Hilfsstruktur (6) gebildet wird, die mindestens eine Flanke der Schichtstruktur (5) bedeckt und die aus einem ersten Hilfsmaterial besteht, das selektiv zum zweiten Material ätzbar ist,
- bei dem eine zweite Hilfsstruktur (7) gebildet wird, die mindestens eine andere Flanke der Schichtstruktur bedeckt und die Schichten aus dem zweiten Material mechanisch verbindet
- bei dem die die Schichtstruktur umgebende Trägeroberfläche (2a) bis zur Oberkante der Schichtstruktur mit einer Füllschicht (8) bedeckt wird
- bei dem die Schichten (5₁) aus dem ersten Material und die erste Hilfsstruktur (6) selektiv zu den Schichten (5₂) aus dem zweiten Material und zur zweiten Hilfsstruktur (7) entfernt werden,
- bei dem der entstandene Hohlraum (H) mit einem edelmetallhaltigen Elektrodenmaterial (9) aufgefüllt wird, so daß eine erste Elektrode gebildet wird, die in dem durch die Schichten aus dem ersten Material gebildeten Hohlraum Lamellen (9_{L}) und in dem durch die erste Hilfsstruktur gebildeten Hohlraum eine die Lamellen verbindende Stützstruktur (9_{S}) aufweist,
- bei dem die den Schichten (5₂) aus dem zweiten Material und die zweite Hilfsstruktur (7) selektiv zum Elektrodenmaterial entfernt werden,
- bei dem auf der freiliegenden Oberfläche der ersten Elektrode ein Kondensatordielektrikum (10) aus einem hoch-ε-dielektrischen oder ferroelektrischen Material konform aufgebracht wird,
- bei dem eine zweite Elektrode (11) auf dem Kondensatordielektrikum erzeugt wird.

2. Herstellverfahren nach Anspruch 1, bei dem als erstes Material undotiertes, n-dotiertes oder p⁻-dotiertes Polysilizium und als zweites Material p⁺-dotiertes Polysilizium verwendet werden.

3. Herstellverfahren nach Anspruch 1 oder 2, bei dem die erste Hilfsstruktur (6) an zwei sich in einer ersten Richtung gegenüber liegenden Flanken der Schichtstruktur erzeugt wird.

4. Herstellverfahren nach einem der Ansprüche 1 bis 3, bei dem die zweite Hilfsstruktur (7) an zwei sich in einer zweiten Richtung gegenüber liegenden Flanken der Schichtstruktur erzeugt wird.

5. Herstellverfahren nach einem der Ansprüche 2 bis 4, bei dem die erste Hilfsstruktur (6) und/oder die zweite Hilfsstruktur (7) durch selektive Silizium-Abscheidung erzeugt werden.

6. Herstellverfahren nach einem der Ansprüche 2 bis 5, bei dem die zweite Hilfsstruktur (7) durch Schrägimplantation mit p-dotierenden Ionen in die Flanke der Schichtstruktur erzeugt wird.

7. Herstellverfahren nach einem der Ansprüche 1 bis 6, bei dem nach der Auffüllung des Hohlraums (H) mit dem Elektrodenmaterial das dabei auf der Füllschicht (8) abgeschiedene Elektrodenmaterial mit einem CMP-Prozeß entfernt wird.

8. Herstellverfahren nach einem der Ansprüche 1 bis 7, bei dem nach der Bildung der ersten Elektrode die Füllschicht (8) selektiv zum Elektrodenmaterial und zur Trägeroberfläche (2a) entfernt wird.

9. Herstellverfahren nach einem der Ansprüche 1 bis 8, bei dem die Schichtenfolge auf einem Träger aufgebracht wird, der an seiner den Kondensator zugewandten Oberfläche eine Isolierschicht (2, 2a) mit einem darin angeordneten Kontakt (3) aufweist, wobei der Kontakt (3) eine Diffusionsbarriere (4) umfaßt und mit der ersten Elektrode (9_{S}, 9_{L}) verbunden wird.

10. Herstellverfahren nach einem der Ansprüche 1 bis 9, bei dem auf dem Träger eine Vielzahl von Kondensatoren hergestellt werden, die in der zweiten Richtung linear angeordnet sind,
- wobei die Schichtenfolge zu in der zweiten Richtung verlaufenden streifenförmigen Schichtstrukturen strukturiert wird und an deren Flanken die ersten Hilfsstrukturen (6) gebildet werden,
- wobei dann die streifenförmigen Schichtstrukturen mit den ersten Hilfsstrukturen zu einer Vielzahl von inselförmigen Schichtstrukturen strukturiert werden,
- wobei an den sich in der zweiten Richtung gegenüberliegenden Flanken jeder Insel die zweiten Hilfsstrukturen (7) erzeugt werden, und
- wobei mit der Füllschicht (8) der gesamte Zwischenraum zwischen den Inseln aufgefüllt wird.

11. Kondensator, der in einer Halbleiteranordnung auf einem Träger angeordnet ist,
- mit einer edelmetallhaltigen ersten Elektrode (9_{L}, 9_{S}),
- mit einem Kondensatordielektrikum (10), das aus einem hoch-ε-dielektrischen oder ferroelektrischen Material besteht,
- mit einer zweiten Elektrode (11),
**dadurch gekennzeichnet**, daß die erste Elektrode mindestens zwei voneinander beabstandete Lamellen (9_{L}) aufweist, die im wesentlichen parallel zur Trägeroberfläche angeordnet sind und über eine Stützstruktur (9_{S}) an einer Flanke der Lamellen miteinander mechanisch und elektrisch verbunden sind.

12. Kondensator nach Anspruch 11, bei dem die Stützstruktur (9_{S}) an zwei gegenüberliegenden Flanken der Lamellen angeordnet ist

13. Kondensator nach einem der Ansprüche 11 bis 12, bei dem der Träger an seiner dem Kondensator zugewandten Oberfläche eine Isolierschicht (2, 2a) mit einem darin angeordneten Kontakt (3) aufweist, wobei der Kontakt (3) eine Diffusionsbarriere (4) umfaßt und mit der ersten Elektrode (9_{S}, 9_{L}) verbunden ist.

14. Kondensator nach Anspruch 13, bei dem der Träger einen MOS-Transistor enthält und der Kontakt (3) ein S/D-Gebiet (12) des Transistors mit der ersten Elektrode (9_{S}, 9_{L}) verbindet.
